(19) Europäisches Patentamt / European Patent Office / Office européen des brevets

(11) **EP 2 704 187 B1**

(12) **EUROPEAN PATENT SPECIFICATION**

(45) Date of publication and mention
of the grant of the patent:
**19.08.2015 Bulletin 2015/34**

(51) Int Cl.:
*H01L 21/768* (2006.01)          *H01L 23/48* (2006.01)
*H01L 23/00* (2006.01)          *H01L 23/31* (2006.01)
*H01L 25/065* (2006.01)

(21) Application number: **13194159.3**

(22) Date of filing: **02.04.2004**

(54) **METHOD FOR PRODUCING ELECTRICAL THROUGH HOLE INTERCONNECTS AND corresponding DEVICE**

Verfahren zur Herstellung von elektrischen Durchkontaktierungen und damit hergestellte Vorrichtung

Procédé de fabrication d'interconnexions traversantes et dispositif correspondant

(84) Designated Contracting States:
**AT BE BG CH CY CZ DE DK EE ES FI FR GB GR HU IE IT LI LU MC NL PL PT RO SE SI SK TR**

(30) Priority: **03.04.2003 EP 03447079**
**03.04.2003 US 460853 P**
**22.09.2003 EP 03447236**
**26.09.2003 US 506560 P**

(43) Date of publication of application:
**05.03.2014 Bulletin 2014/10**

(62) Document number(s) of the earlier application(s) in
accordance with Art. 76 EPC:
**04447086.2 / 1 465 246**

(73) Proprietor: **IMEC**
**3001 Leuven (BE)**

(72) Inventors:
• **Beyne, Eric**
**B-3001 LEUVEN (BE)**
• **Labie, Riet**
**B-3001 LEUVEN (BE)**

(74) Representative: **Pronovem**
**Office Van Malderen**
**Avenue Josse Goffin 158**
**1082 Bruxelles (BE)**

(56) References cited:
**JP-A- S61 248 534          US-A1- 2002 017 710**
**US-A1- 2002 027 293          US-A1- 2002 048 916**

## Description

## Field of the invention

The present invention is related to the field of electrical interconnection technologies for microelectronics system elements. In particular the present invention is related to methods for producing electrical through hole interconnects.

## State of the art

The evolution of VLSI technology asks for an increasing bandwidth of interconnects between IC's and/or other system elements. For short interconnects electrical signal lines maintain the highest capacity and speed. In order to keep up with the increasing speed and density requirements, system in a package (SIP) technology is increasingly used. This creates the need for 3-dimensional interconnects.

An example of the fabrication of such interconnects can be found in patent US-B-6184060. Vias or through holes are made in the front side of the wafer, and dielectric and contact pad metal are deposited into the vias. Then the wafer back side is etched until the back metal is exposed. This method requires the back side etching up until the contact pad, including etching the dielectric deposited on the bottom of the vias. The patent indicates Silicon oxide or BPSG as material for the dielectric, deposited by CVD (Chemical Vapour Deposition). Also thermal oxidation is mentioned. Etching Silicon oxide with respect to silicon is not trivial and cannot be done anisotropically. Silicon oxide deposition produces layers with essentially uniform thickness, which limits design freedom.

Documents US2002/048916 and US2002/017710 are related to a stack of substrates having an internal contact and including through-hole interconnects having a dielectric collar and a metallization.

## Aims of the invention

The present invention aims to provide a novel method for producing via or through hole interconnects between microelectronic elements, which is relatively easy to perform and can be applied relatively cheaply compared to the state of the art. The method should for instance be applicable in thin chip technology as MCM (Multi Chip Module) and system in a package (SIP) technology.

## Summary of the invention

The present invention relates to chip to wafer bonding and more specifically to an interconnect scheme for already bonded chips. This method for the fabrication of a device comprising electrical through hole interconnects is disclosed in the appended claims. The method comprises the steps of: A) providing a substrate, typically covered by an oxide layer and comprising an open contact, B) bonding a silicon die to said substrate, whereby an internal contact is created by flipping said silicon die with a metal pad on its upper surface, said metal pad being covered with an oxide layer, said internal contact being isolated by a first layer of a first dielectric material, and C) thinning said bonded silicon die without revealing said internal contact,

D) dry etching said silicon die, forming at least one substrate hole, until said first layer of said first dielectric material in said internal contact is reached,
E) dry etching said first layer of said first dielectric material at the bottom of said substrate hole,
F) depositing a second layer of a second dielectric material, said substrate hole thereby being filled,
G) depositing and patterning a thin Aluminium hard-mask layer, and dry etching in said second layer of said second dielectric material within said substrate hole in said silicon die, forming a dielectric hole within said substrate hole, whereby the sidewalls of said substrate hole remain covered with said second layer of said second dielectric material, until the bottom of said substrate hole is reached,
H) depositing a thick Aluminium layer, creating an interconnect between said open contact and said internal contact, thereby transforming said dielectric hole into a conductor hole, and etching said thick Aluminium layer,
I) depositing a third layer of a third dielectric material, thereby filling said conductor hole.

The substrate preferably is a silicon wafer. The substrate hole may be circular shaped.

The step of dry etching the silicon die is performed by etching through the silicon die until the oxide layer is reached. The step of dry etching the first layer of first dielectric material is performed by etching said oxide layer.

In a preferred embodiment the second and the third dielectric material are benzocyclobutene (BCB) and the second layer of said second dielectric material and the third layer of said third dielectric material are deposited by BCB spin coating. Alternatives for a BCB coating can be silicone layers or parylene CVD coatings. BCB and silicone layers can also be spray-coated.

According to an embodiment, the method of the invention further comprises the steps of :

(J) anisotropically dry etching in said third layer of dielectric material within said previous conductor hole, forming at least one dielectric hole within said previous conductor hole, whereby the sidewalls of said previous conductor hole remain covered with said third layer of dielectric material, until the bottom of said previous conductor hole is reached,
(K) depositing a next layer of conducting material on the bottom and on the sidewalls of said dielectric hole in said third layer of dielectric material, thereby transforming said dielectric hole into a conductor hole,

(L) depositing a next layer of a further patternable dielectric material on top of said next layer of conducting material, said conductor hole thereby being filled.

According to another embodiment, the method of the invention further comprises the steps of:

(J) anisotropically dry etching in said third layer of dielectric material within said previous conductor hole, forming at least one dielectric hole within said previous conductor hole, whereby the sidewalls of said previous conductor hole remain covered with said third dielectric material, until the bottom of said previous conductor hole is reached,
(K) removing said conducting material from the bottom of said dielectric hole,
(L) depositing a next layer of a further patternable dielectric material, whereby said dielectric hole is filled,
(M) anisotropically dry etching in said next layer of patternable dielectric material within said dielectric hole, forming a new dielectric hole within said dielectric hole, whereby the remains of said dielectric hole remain covered with said next layer of patternable dielectric material, until the bottom of said substrate hole is reached,
(N) depositing a next layer of conducting material on the bottom and on the sidewalls of said new dielectric hole in said next layer of patternable dielectric material, thereby transforming said new dielectric hole into a conductor hole,
(O) depositing a next layer of a further patternable dielectric material on top of said next layer of conducting material.

According to an embodiment, the method of the invention reapplies the further steps (J,K,L) for a finite number of times. According to another embodiment, the method of the invention reapplies the further steps (J,K,L,M,N,O) for a finite integer number of times.
In another aspect the invention relates to a device comprising electrical through hole interconnects according to the appended claims.

## Short description of the drawings

Fig. 1 (steps 1A to 1F) illustrates a method that is applicable in the present invention. Steps 1G and 1H illustrate preferred further optimal steps.
Fig. 2 represents a method with optimal further steps 2G and 2H.
Fig. 3 represents a method, wherein the method of Figures 1 or 2 is also applied on the back side of the substrate.
Fig. 4 represents a sequence of steps according to another method with several layers of dielectric and conducting material.
Fig. 5 represents an alternative to the method of Fig. 4.
Fig. 6 represents the method according to the invention, related to chip to wafer bonding.

## Detailed description of the invention

The methods and examples described below do not limit the scope of the idea and they can be slightly changed by ordinary steps known in the art in order to optimise applicability in specific practical situations. Some preferred practical methods are described below.
For the purpose of this invention, the terms 'next layer of dielectric/conducting material' and 'previous layer of dielectric/conducting material' should be understood as the next or previous layer of dielectric/conducting material, respectively, with respect to the moment of deposition. Furthermore the term 'patternable' means that the layer can be patterned. Typically this must be possible at a scale smaller than the hole size. Preferably the patterning of said patternable dielectric material is performed by plasma-etching and/or lithographic techniques. The term 'dielectric hole' is used for a hole whereof the sidewalls are covered with a dielectric material, whereas a 'conductor hole' has sidewalls and bottom covered with a layer of conducting material. The various steps of the method are numbered in capitals, starting from A). However, it is not always obligatory to perform all steps in alphabetical order, as some steps can constitute an alternative to certain steps that were previously mentioned. The numbering rather refers to that used in the figures.
A method is disclosed to make isolated through holes or vias in a substrate. In short through holes are fabricated according to an exemplary method as follows :

-    dry etching holes in Si-wafer (25 - 50 micron),
-    benzocyclobutene (BCB) coating & hole filling,
-    dry etching BCB holes concentric to Si-holes (15 - 40 micron),
-    depositing seed layer & electroplating thick copper (e.g. 5 - 10 micron),
-    providing an additional BCB passivation layer.

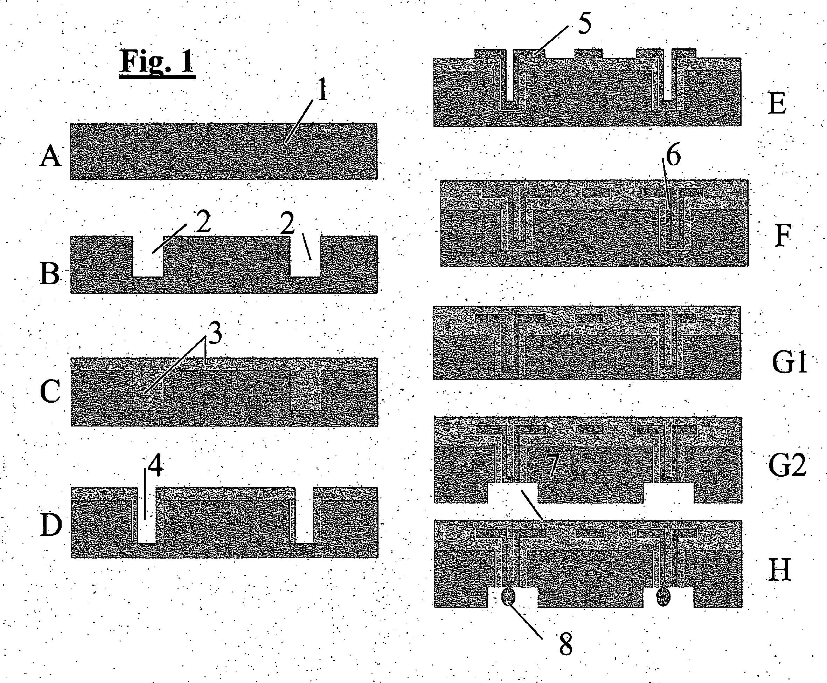

Advantageously another step can be added, namely a step of dry etching Si from the wafer backside, stopping on the copper.
Each step of the method is now described more in detail.
The method preferably comprises the following steps (see Fig.1):

A) Providing a substrate (1) (Fig. 1A); the substrate can be a wafer or a processed wafer. It can be a microelectronics component, possibly bonded to a wafer. Preferably the substrate is a semiconductor substrate. More preferably the substrate is a silicon substrate. Preferably the substrate thickness is between 10 μm and 500 um. More preferably the substrate thickness is between 20 μm and 300 μm.

B) Dry etching in said substrate, forming at least one substrate hole (2). These substrate holes (2) can have different shapes and dimensions in the same substrate (1). The etching can be performed by different methods known in the state of the art. For instance Reactive Ion Etching- Inductive Coupled Plasma (RIE-ICP) can be used. Preferably these holes are cylindrical, corresponding to a circular opening on the surface (Fig.1B). The holes have a width of 25 μm, but bigger and smaller holes are possible. Preferably the holes have a width between 20 μm and 100 μm. Typical holes can have an aspect ratio of 1:5, the aspect ratio being defined as

$$\frac{width}{depth}\bigg|_{hole}$$ • Aspect ratios of 1:10 or higher are not excluded. A vacuum step can be required to ensure proper filling of the Si substrate holes. For benzocyclobutene (BCB) this is preferably performed at 170°C, as this material exhibits its largest flow at that temperature, before it starts to cure at higher temperatures. An alternative method could be the lamination of a dielectric layer, followed by a vacuum reflow step, filling the holes and planarising the substrate in a single step.

C) depositing a first layer of patternable dielectric material (3) on said substrate (1), whereby said substrate holes (2) are filled and the substrate surface is planarised (Fig.1C). Advantageously the patternable dielectric material is a polymer or silicone. The dielectric material is preferably deposited by spin-coating, spray-coating or lamination techniques. More preferably the patternable dielectric is benzocyclobutene (BCB). Even more preferably non-photo BCB is used for this step, due to its good hole filling and planarisation properties. One or multiple coatings can be required.

D) anisotropically dry etching in the first layer of patternable dielectric material (3) within the substrate hole, forming at least one dielectric hole (4) within the substrate hole (2) (Fig.1D). The sidewalls of the substrate hole (2) hereby remain covered with said first layer of patternable dielectric material (3), until the bottom of said substrate hole (2) is reached. The dielectric hole (4) can have any shape and different shapes of holes can be present in the same dielectric layer. Several dielectric holes (4) can be present in the same substrate hole. Preferably the holes (4) are circular or ring shaped. Preferably the substrate hole (2) and the dielectric hole (4) in the first layer of patternable dielectric material (3) are positioned coaxially.

E) Depositing a layer of conducting material (5) on the bottom and on the sidewalls of the dielectric hole in the layer of patternable dielectric material, whereby the dielectric hole (4) is transformed into a conductor hole (Fig.1E). This step is preferably performed by depositing a seed layer and performing electroplating of the conducting material. This step can cover the whole surface of the wafer. This step may also be performed for instance by Chemical Vapour Deposition (CVD), by Physical Vapour Deposition (PVD), Electro Chemical Deposition (ECD), sputtering techniques as well as by any other method known in the art. Preferably the conducting material (5) is a metal. More preferably the conducting material (5) is copper or aluminium. The step of depositing a conducting material possibly creates an interconnect with an external contact. This step can comprise various substeps. Typically physical vapour deposition (PVD) of e.g. a plating seed layer of 30nm Ti/400 nm Cu is used. The thickness of the Cu on the sidewalls and bottom of the holes may be increased by using electroless Cu plating. This is followed by the deposition of a resist layer, in order to perform pattern plating. After plating the resist and the plating seed layer are stripped from the wafer.

In an alternative method the above-mentioned steps (C), (D), and (E) are replaced by applying Resin Coated Foils, preferably Resin Coated Copper foils. These foils are positioned on top of the substrate, after which they are pressed against the substrate, and thereby fill the hole(s) with a first layer of resin (preferably BCB) and a copper layer.

F) depositing a second layer of a second patternable dielectric material (6) on top of the layer of conducting material (5), hereby filling the gap in the obtained through hole metal fill (Fig.1F). This layer can serve as an external isolation layer. Preferably the second patternable dielectric material is a polymer or silicone. The dielectric material is preferably deposited by spin-coating, spray-coating or lamination techniques. More preferably the second patternable dielectric is benzocyclobutene (BCB) as it has excellent planarisation and gap fill properties. A vacuum step is required to ensure proper filling of the gaps for instance between between the Cu and the Si. For BCB this is preferably performed at 170°C as the material exhibits its largest flow at that temperature, before it starts to cure at higher temperatures. Preferably the first (3) and second (6) patternable dielectric material are the same.

For the interconnects, an aspect ratio (defined as $\frac{width}{depth}\bigg|_{interconnect}$ ) of 1:5 even 1:10 is easily achievable. Aspect ratios of 1:20 and more can be achieved.

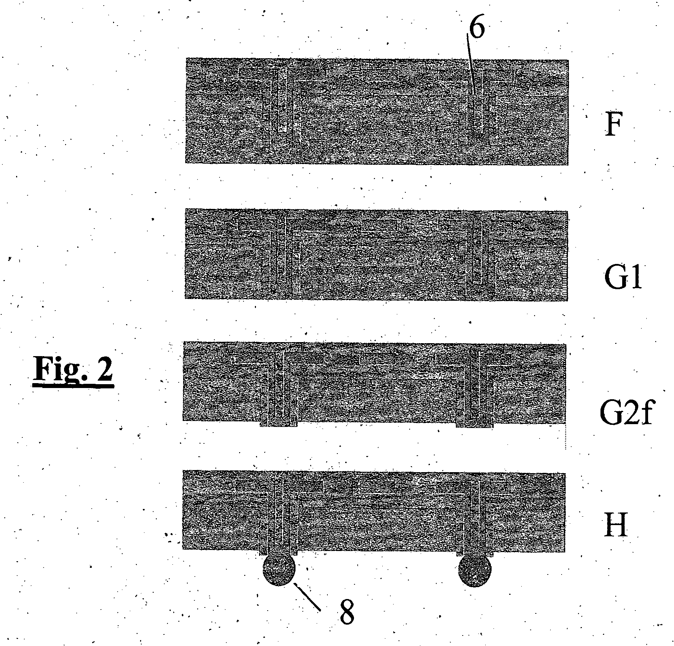

Preferably the method further comprises optional steps such as a wafer backgrinding step (Fig.1G1 ≡ Fig.2G1) (preferably until the wafer is 10 μm to 50 μm thicker than the metal via post).

According to an exemplary method the optimal steps are :

G) Dry etching or plasma etching the substrate from the backside, hereby possibly creating holes (7) and halting when the conducting material and dielectric material are reached (Fig.1G2). Even more preferably the step of plasma etching does not stop after that the level where the conducting material and dielectric material are reached (for instance copper/BCB plugs), but continues above that level (thus slightly overetching the silicon) (Fig.2G2f). The conducting material and dielectric material will then come out of the etched back surface, which is advantageous for the addition of solder bumps. H) The addition of solder bumps (8) on the studs of conducting material, for bonding purposes (Fig.1H and Fig. 2H).

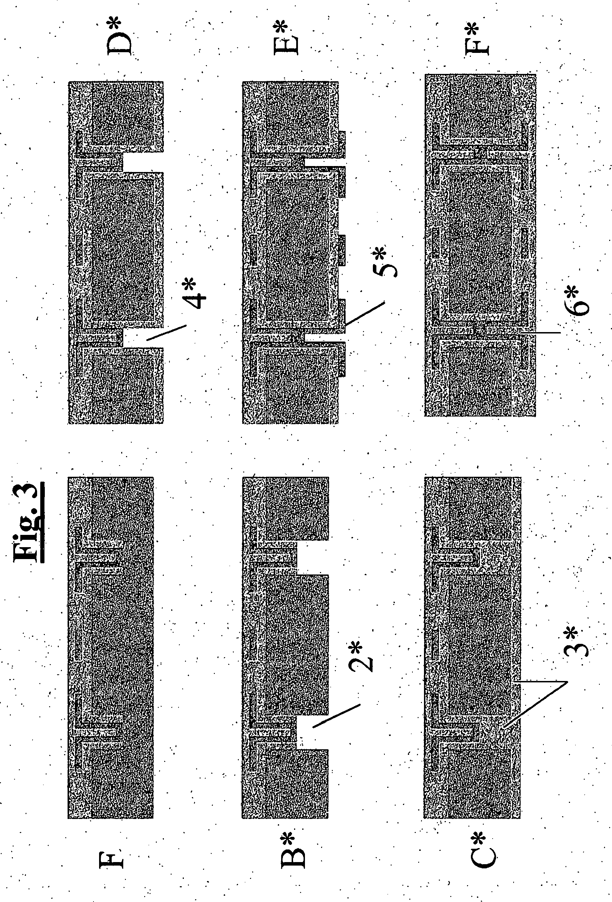

In another method (Fig. 3), the method as previously described is applied first on the front side of a substrate (resulting in Fig. 3F) ≡ Fig. 2F ≡ Fig. 1F), followed by applying the method on the back side (steps B*, C*, D*, E* and F*, respectively), whereby the holes in front and back side (2 and 2*, 4 and 4*, respectively) are co-aligned and 2* is created such that it reaches the conducting material layer (5), such that isolated through hole interconnects are produced passing from the front side of said substrate to the backside of said substrate. Doing so the aspect ratios achievable by a single process can be essentially doubled. For the interconnect aspect ratios of 1:20 are then easily achievable. Aspect ratios of 1:40 and more can even be achieved.

In exemplary methods different dielectric holes and thus corresponding interconnects are present in one substrate hole and the dielectric holes are made such that a predetermined electromagnetic field is created between the different interconnects when they carry a signal.

In exemplary methods the interconnect structures are made such that coaxial cable interconnects are produced. Coaxial interconnects that are able to carry signals with frequencies up to 77 GHz and even up to 100 GHz can be achieved when using BCB as dielectric material.

In exemplary methods N-fold interconnects can be provided by creating ring shaped, coaxial dielectric holes or variations thereof. In typical methods N equals 2.

The dielectric holes can be completely filled with conducting material.

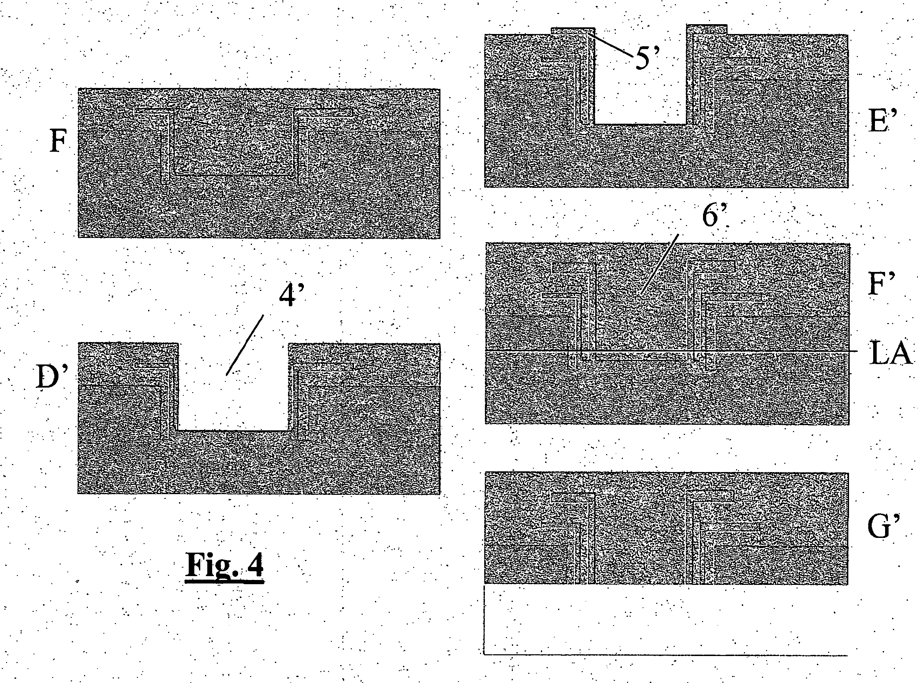

In another method (Fig. 4), the method comprises -starting from the situation in Fig.4F- the further steps:

I) anisotropically dry etching in the previous layer of patternable dielectric material within a previous conductor hole formed by a previous layer of conductive material, such that at least one dielectric hole (4') is formed within the previous conductor hole. The sidewalls of the previous conductor hole remain covered with the previous layer of patternable dielectric material, until the bottom of said previous conductor hole is reached. (Fig.4D')

J) depositing a next layer of conducting material (5') on the bottom and on the sidewalls of said dielectric hole in said previous layer of patternable dielectric material, thereby transforming the dielectric hole (4') into a conductor hole (Fig.4E'). This step (J) can create an interconnection with an external contact.

K) depositing a next layer of a further patternable dielectric material (6') on top of said next layer of conducting material deposited in the previous step (Fig.4F'). An additional step of thinning the substrate from the back side up until a level LA is reached, is preferred (Fig.4G'). The level LA must be high enough such that the material on the bottom of the different layers of conducting material are removed. This way the method allows making 'coaxial cable' interconnects.

According to another method, the set of steps (I, J, K) are repeated for a finite integer number of times N, such that N-fold electrical interconnects are produced. An additional step of thinning the substrate from the back side until at least a level LA is reached is preferred. This way the method allows making N-fold 'coaxial cable' interconnects.

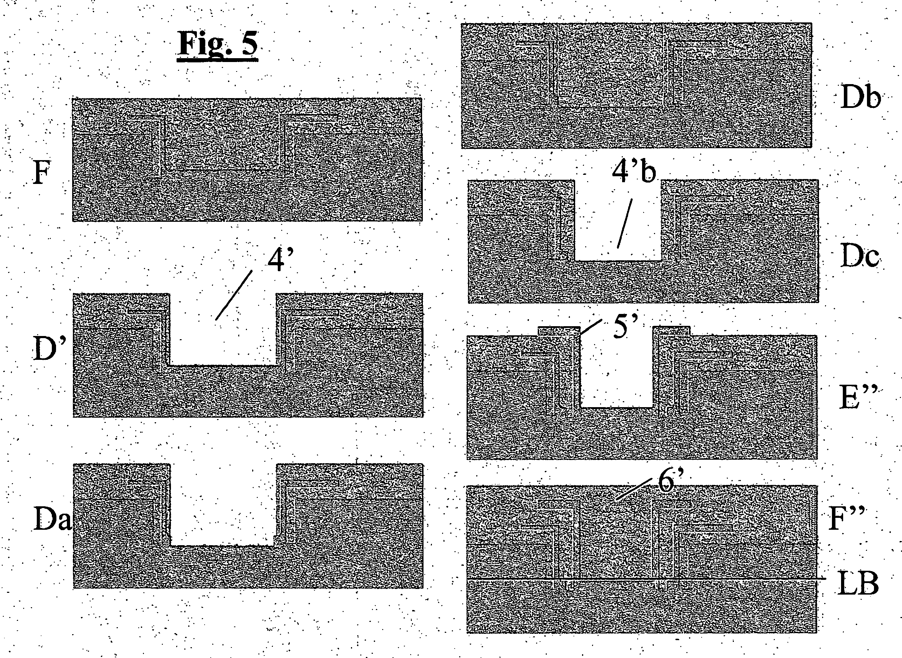

According to another method, represented in Fig. 5, the method comprises - starting from the situation in Fig.5F - the further steps:

L) Anisotropically dry etching in the previous layer of patternable dielectric material within the previous conductor hole formed by the previous layer of conductive material, forming at least one dielectric hole (4') within said previous conductor hole. The sidewalls of the previous conductor hole remain covered with said previous patternable dielectric material, until the bottom of the previous conductor hole is reached (Fig.5D').

M) Removing the conducting material from the bottom of the dielectric hole until the substrate material is reached on the bottom of the dielectric hole (Fig. 5Da).

N) Depositing a next layer of a further patternable dielectric material, whereby the dielectric hole is filled (Fig.5Db).

O) Anisotropically dry etching in the 'next layer of patternable dielectric material within the dielectric hole, forming a new dielectric hole (4'b) within the dielectric hole (4') such that the remains of the dielectric hole (4') remain covered with the next layer of patternable dielectric material, until the bottom of the substrate holes is reached (Fig.5Dc).

P) Depositing a next layer of conducting material (5') on the bottom and on the sidewall of said new dielectric hole (4'b) in said next layer of patternable dielectric material, thereby transforming said new dielectric hole (4'b) into a conductor hole (Fig.5E'').

Q) Depositing a next layer (6') of a further patternable dielectric material on top of said next layer of conducting material (5') (Fig.5F'').

An additional step of thinning the substrate from the back side up until a level LB is reached is preferred. The level LB must be high enough such that the material on the bottom of the different layers of conducting material are removed. This way the method again allows making 'coaxial cable' interconnects.

According to another method, the set of steps (L, M, N, O, P, Q) according to the previous method can also be repeated for a finite integer number of times (*n*), such that *n*-fold electrical interconnects can be produced. An additional step of thinning the substrate from the back side up until a level LB is reached is preferred. Step (P) can advantageously create an interconnection with an external contact. This way the method allows again making n-fold 'coaxial cable' interconnects.

The above-described methods offer different advantages. They allow the production of multiple metal connections through a single Si hole. For example they allow for radio frequency (RF) coax transitions.

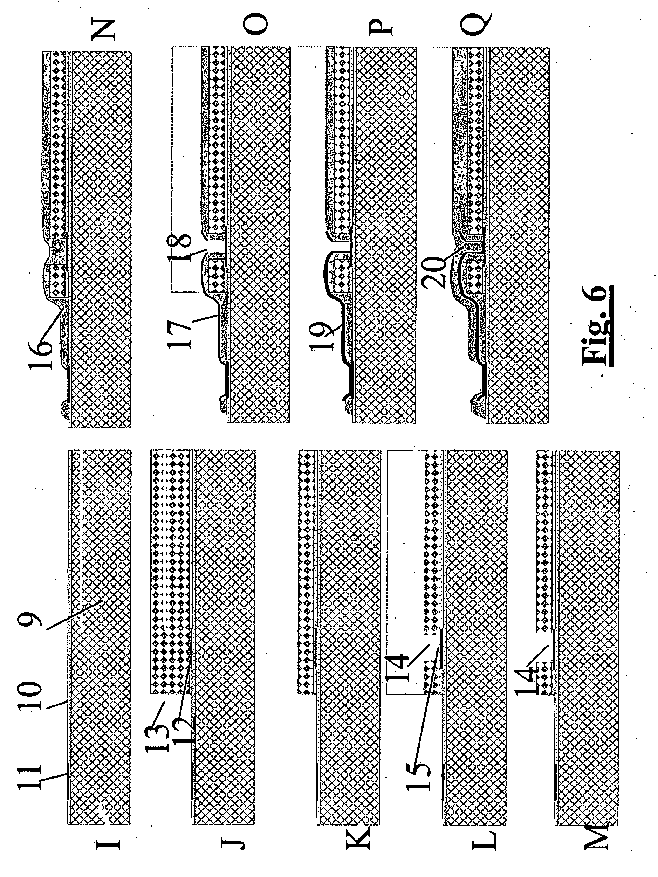

The present invention is particularly related to chip to wafer bonding and more specifically to an interconnect scheme for already bonded chips. It comprises the following steps (Fig. 6):

A) providing a substrate (9), e.g. a silicon wafer, typically covered by an oxide layer (10), which comprises an open contact (11) (Fig. 6I),

B) Performing silicon die (13) to wafer bonding next to the open contact, whereby the silicon die has an internal contact (12) or an internal contact (12) is created, the internal contact is created by flipping a die with an Aluminum pad on its upper surface (Fig. 6J), which is typically first covered with an oxide layer. The internal contacts are typically isolated by a first layer of dielectric material,

C) Thinning the bonded die on wafer level. Hereby the internal contact is not revealed (Fig. 6K),

D) Dry etching in the thin Si-die (14), forming a preferably circular substrate hole (20-40 micron diameter), until the dielectric isolation layer of the internal contact is reached. In the flip-chip example this means etching through the die until the oxide layer covering the Al pads (15) is reached (Fig. 6L),

E) Etching the first layer of dielectric material, which is isolating the internal contact, at the bottom of the substrate hole. In the flip-chip example this means etching the oxide layer covering the Al pads (15) (Fig. 6M),

F) BCB spin coating on wafer level, hereby filling the substrate hole(s) (14) and creating a layer of BCB (16) (Fig. 6N),

G) Depositing and patterning a thin Aluminum hardmask layer (17) (Fig. 6O), and dry etching in the layer of BCB (18) within the substrate hole in the die, forming a dielectric hole (10-20 micron diameter) within said substrate hole, whereby the sidewalls of the substrate hole remain covered with BCB, until the bottom of said substrate holes is reached (Fig. 6O),

H) Depositing a thick Aluminum layer (19) with good step coverage. This step is creating the interconnect between the open contact (11) and the internal contact (12), thereby transforming the dielectric hole into a conductor hole (Fig. 6P), and etching the thick Aluminum layer (19),

I) Depositing an additional BCB passivation layer (20) by spin coating BCB, thereby filling the conductor hole (Fig. 6Q).

The methods described with respect to Figures 1 to 5 are applicable at least partially in the production of the through hole connection between contacts 11 and 12 in the method according to the invention described with respect to Figure 6. In the BCB-filled conductor hole of Figure 6Q for example, at least some of the steps described with respect to Figures 4 and 5 may be performed to create coaxial through hole connections in said conductor hole.

## Claims

1. Method for the fabrication of a device comprising electrical through hole interconnects, comprising the steps of:

A) providing a substrate (9), typically covered by an oxide layer (10) and comprising an open contact (11),

B) bonding a silicon die (13) to said substrate, whereby an internal contact (12) is created by flipping said silicon die with a metal pad on its upper surface, said metal pad being covered with an oxide layer, said, internal contact being isolated by a first layer of a first dielectric material,

C) thinning said bonded silicon die (13) without revealing said internal contact (12),

D) dry etching said silicon die (13), forming at least one substrate hole (14), until said first layer of said first dielectric material in said internal contact is reached,

E) dry etching said first layer of said first dielectric material at the bottom of said substrate hole (14),

F) depositing a second layer (16) of a second dielectric material, said substrate hole (14) thereby being filled,

G) depositing and patterning a thin metal hard-mask layer (17), and dry etching in said second layer of said second dielectric material within said substrate hole in said silicon die, forming a dielectric hole (18) within said substrate hole, whereby the sidewalls of said substrate hole remain covered with said second layer of said second dielectric material, until the bottom of said substrate hole is reached,

H) depositing a thick metal layer (19), creating an interconnect between said open contact (11) and said internal contact (12), thereby transforming said dielectric hole into a conductor hole, and etching said thick metal layer (19),

I) depositing a third layer (20) of a third dielectric material, thereby filling said conductor hole.

2.  Method according to claim 1, wherein said substrate (9) is a silicon wafer.

3.  Method according to claim 1 or 2, wherein said substrate hole (2) is circular shaped.

4.  Method according to any of claims 1 to 3, wherein said metal is Aluminium.

5.  Method according to claim 1, wherein the step of dry etching said silicon die (13) is performed by etching through said silicon die until said oxide layer is reached.

6.  Method according to claim 5, wherein the step of dry etching said first layer of first dielectric material is performed by etching said oxide layer.

7.  Method according to any of claims 1 to 6, wherein said second dielectric material and said third dielectric material is benzocyclobutene (BCB) and said second layer of said second dielectric material and said third layer of said third dielectric material is deposited by BCB spin coating.

8.  Method according to any one of claims 1 to 7, further comprising the steps of:

    (J) anisotropically dry etching in said third layer of dielectric material within said previous conductor hole, forming at least one dielectric hole (4') within said previous conductor hole, whereby the sidewalls of said previous conductor hole remain covered with said third layer of dielectric material, until the bottom of said previous conductor hole is reached,

    (K) depositing a next layer of conducting material (5') on the bottom and on the sidewalls of said dielectric hole (4') in said third layer of dielectric material, thereby transforming said dielectric hole (4') into a conductor hole,

    (L) depositing a next layer of a further patternable dielectric material (6') on top of said next layer of conducting material (5'), said conductor hole thereby being filled.

9.  Method according to any one of claims 1 to 7, further comprising the steps of:

    (J) anisotropically dry etching in said third layer of dielectric material within said previous conductor hole, forming at least one dielectric hole (4') within said previous conductor hole, whereby the sidewalls of said previous conductor hole remain covered with said third dielectric material, until the bottom of said previous conductor hole is reached,

    (K) removing said thick metal layer from the bottom of said dielectric hole,

    (L) depositing a next layer of a further patternable dielectric material, whereby said dielectric hole is filled,

    (M) anisotropically dry etching in said next layer of patternable dielectric material within said dielectric hole, forming a new dielectric hole (4'b) within said dielectric hole (4'), whereby the remains of said dielectric hole (4') remain covered with said next layer of patternable dielectric material, until the bottom of said substrate hole is reached,

    (N) depositing a next layer of conducting material (5') on the bottom and on the sidewalls of said new dielectric hole (4'b) in said next layer of patternable dielectric material, thereby transforming said new dielectric hole (4'b) into a conductor hole,

    (O) depositing a next layer of a further patternable dielectric material (6') on top of said next layer of conducting material (5').

10. Method for the fabrication of devices comprising multilevel electrical through hole interconnects according to claim 8, **characterised in that** it reapplies the further steps (J,K,L) for a finite number of times.

11. Method for the fabrication of devices comprising multilevel electrical through hole interconnects according to claim 9, **characterised in that** it reapplies the further steps (J,K,L,M,N,O) for a finite integer number of times.

12. Device comprising electrical through hole interconnects, the device comprising:

    a substrate (9), typically covered by an oxide layer (10) and comprising an open contact (11), with a silicon die (13) bonded to said substrate, and wherein the assembly of the substrate and the die comprises an internal contact (12),

wherein a conductor hole is formed above said internal contact, said conductor hole comprising a substrate hole extending through said silicon die to said internal contact (12),

a first dielectric layer (16) formed on the sidewalls of said substrate hole and on the silicon die,

a metal layer (19) comprising a first portion on the dielectric layer on the sidewalls of the substrate hole, and

a second dielectric layer (20) on said metal layer, the second dielectric layer filling the volume inside the conductor hole,

and wherein the metal layer (19) further comprises a second portion at the bottom of the conductor hole which contacts the internal contact, and a third portion extending from the conductor hole to the open contact (11), thereby connecting the open contact (11) and the internal contact (12).

**Patentansprüche**

1. Verfahren zum Herstellen einer Einheit, die elektrische Durchkontaktierungsverbindungen umfasst, das die Schritte umfasst:

A) Bereitstellen eines Substrats (9), das für gewöhnlich von einer Oxidschicht (10) bedeckt ist und einen offenen Kontakt (11) umfasst,

B) Binden eines Siliciumchips (13) an das Substrat, wobei ein interner Kontakt (12) durch Flippen des Siliciumchips mit einem Metallplättchen auf dessen Oberfläche gebildet wird, wobei das Metallplättchen mit einer Oxidschicht bedeckt ist, wobei der interne Kontakt durch eine erste Schicht eines ersten dielektrischen Materials isoliert ist,

C) Ausdünnen des gebundenen Siliciumchips (13) ohne dabei den internen Kontakt (12) freizulegen,

D) Trockenätzen des Siliciumchips (13), wobei zumindest ein Substratloch (14) gebildet wird, bis die erste Schicht des ersten dielektrischen Materials im internen Kontakt erreicht ist,

E) Trockenätzen der ersten Schicht des ersten dielektrischen Materials am Boden des Substratlochs (14),

F) Abscheiden einer zweiten Schicht (16) eines zweiten dielektrischen Materials, wobei dadurch das Substratloch (14) gefüllt wird,

G) Abscheiden und Strukturieren einer dünnen Metallhartmaskenschicht (17), und Trockenätzen in der zweiten Schicht des zweiten dielektrischen Materials innerhalb des Substratlochs im Siliciumchip, wobei ein dielektrisches Loch (18) innerhalb des Substratlochs gebildet wird, wobei die Seitenwände des Substratlochs mit der zweiten Schicht des zweiten dielektrischen Materials bedeckt bleiben, bis der Boden des Substratlochs erreicht ist,

H) Abscheiden einer dicken Metallschicht (19), wobei eine Verbindung zwischen dem offenen Kontakt (11) und dem internen Kontakt (12) gebildet wird, wodurch das dielektrische Loch in ein Leiterloch umgewandelt wird, und Ätzen der dicken Metallschicht (19),

I) Abscheiden einer dritten Schicht (20) eines dritten dielektrischen Materials, wodurch das Leiterloch gefüllt wird.

2. Verfahren nach Anspruch 1, wobei das Substrat (9) ein Siliciumwafer ist.

3. Verfahren nach Anspruch 1 oder 2, wobei das Substratloch (2) kreisförmig ist.

4. Verfahren nach einem der Ansprüche 1 bis 3, wobei das Metall Aluminium ist.

5. Verfahren nach Anspruch 1, wobei der Schritt des Trockenätzens des Siliciumchips (13) durch Ätzen durch den Siliciumchip durchgeführt wird, bis die Oxidschicht erreicht ist.

6. Verfahren nach Anspruch 5, wobei der Schritt des Trockenätzens der ersten Schicht des ersten dielektrischen Materials durch Ätzen der Oxidschicht durchgeführt wird.

7. Verfahren nach einem der Ansprüche 1 bis 6, wobei das zweite dielektrische Material und das dritte dielektrische Material Benzocyclobuten (BCB) ist und die zweite Schicht des zweiten dielektrischen Materials und die dritte Schicht des dritten dielektrischen Materials mittels BCB-Spin-Coating abgeschieden werden.

8. Verfahren nach einem der Ansprüche 1 bis 7, das darüber hinaus die Schritte umfasst:

(J) anisotropes Trockenätzen in der dritten Schicht dielektrischen Materials innerhalb des vorherigen Leiterlochs, wobei zumindest ein dielektrisches Loch (4') innerhalb des vorherigen Leiterlochs gebildet wird, wobei die Seitenwände des vorherigen Leiterlochs mit der dritten Schicht dielektrischen Materials bedeckt bleiben, bis der Boden des vorherigen Leiterlochs erreicht ist,

(K) Abscheiden einer nächsten Schicht leitenden Materials (5') am Boden und auf den Seitenwänden des dielektrischen Lochs (4') in der dritten Schicht dielektrischen Materials, wodurch das dielektrische Loch (4') in ein Leiterloch umgewandelt wird,

(L) Abscheiden einer nächstens Schicht eines weiteren strukturierbaren dielektrischen Materials (6') oben auf der nächsten Schicht leitenden Materials (5'), wobei dadurch das Leiterloch gefüllt wird.

**9.** Verfahren nach einem der Ansprüche 1 bis 7, das darüber hinaus die Schritte umfasst:

(J) anisotropes Trockenätzen in der dritten Schicht dielektrischen Materials innerhalb des vorherigen Leiterlochs, wobei zumindest ein dielektrisches Loch (4') innerhalb des vorherigen Leiterlochs gebildet wird, wobei die Seitenwände des vorherigen Leiterlochs mit dem dritten dielektrischen Material bedeckt bleiben, bis der Boden des vorherigen Leiterlochs erreicht ist,

(K) Entfernen der dicken Metallschicht vom Boden des dielektrischen Lochs,

(L) Abscheiden einer nächsten Schicht weiteren strukturierbaren dielektrischen Materials, wobei das dielektrische Loch gefüllt wird,

(M) anisotropes Trockenätzen in der nächsten Schicht strukturierbaren dielektrischen Materials innerhalb des dielektrischen Lochs, wobei ein neues dielektrisches Loch (4'b) innerhalb des dielektrischen Lochs (4') gebildet wird, wobei der Rest des dielektrischen Lochs (4') mit der nächsten Schicht strukturierbaren dielektrischen Materials bedeckt bleibt, bis der Boden des Substratlochs erreicht ist,

(N) Abscheiden einer nächsten Schicht leitfähigen Materials (5') am Boden und auf den Seitenwänden des neuen dielektrischen Lochs (4'b) in der nächsten Schicht strukturierbaren dielektrischen Materials, wodurch das neue dielektrische Loch (4'b) in ein Leiterloch umgewandelt wird,

(O) Abscheiden einer nächsten Schicht weiteren strukturierbaren dielektrischen Materials (6') oben auf der nächsten Schicht leitfähigen Materials (5').

**10.** Verfahren zum Herstellen von Einheiten die elektrische Durchkontaktierungsverbindungen mit mehreren Ebenen umfassen, nach Anspruch 8, **dadurch gekennzeichnet dass** die weiteren Schritte (J, K, L) für eine begrenzte Anzahl von Malen wiederholt werden.

**11.** Verfahren zum Herstellen von Einheiten die elektrische Durchkontaktierungsverbindungen mit mehreren Ebenen umfassen, nach Anspruch 9, **dadurch gekennzeichnet, dass** die weiteren Schritte (J, K, L, M, N, O) für eine begrenzte ganzzahlige Anzahl von Malen wiederholt werden.

**12.** Einheit die elektrische Durchkontaktierungsverbindungen umfasst, wobei die Einheit umfasst:

ein Substrat (9), das typischerweisevon einer Oxidschicht (10) bedeckt ist und einen offenen Kontakt (11) umfasst, mit einem an das Substrat gebundenen Siliciumchip (13), und wobei die Baugruppe des Substrats und des Chips einen internen Kontakt (12) umfasst,
wobei ein Leiterloch über dem internen Kontakt gebildet ist, wobei das Leiterloch umfasst
ein Substratloch das sich durch den Siliciumchip zum internen Kontakt (12) erstreckt,
eine erste dielektrische Schicht (16) die auf den Seitenwänden des Substratlochs und am Siliciumchip gebildet ist,
eine Metallschicht (19) die einen ersten Abschnitt auf der dielektrischen Schicht auf den Seitenwänden des Substratlochs umfasst, und
eine zweite dielektrische Schicht (20) auf der Metallschicht, wobei die zweite dielektrische Schicht das Volumen innerhalb des Leiterlochs füllt,
und wobei die Metallschicht (19) darüber hinaus einen zweiten Abschnitt am Boden des Leiterlochs, der den internen Kontakt berührt, und einen dritten Abschnitt umfasst, der sich vom Leiterloch zum offenen Kontakt (11) erstreckt, wodurch der offene Kontakt (11) und der interne Kontakt (12) verbunden werden.

## Revendications

**1.** Procédé pour la fabrication d'un dispositif comprenant des interconnexions électriques à trous traversants, comprenant les étapes suivantes :

A) la fourniture d'un substrat (9), d'ordinaire couvert par une couche d'oxyde (10) et comprenant un contact ouvert (11),
B) le collage d'une puce de silicium (13) sur ledit substrat, moyennant quoi un contact interne (12) est créé en retournant ladite puce de silicium présentant une pastille métallique sur sa surface supérieure, ladite pastille métallique étant couverte par une couche d'oxyde, ledit contact interne étant isolé par une première couche en un premier matériau diélectrique,
C) l'amincissement de ladite puce de silicium collée (13) sans exposer ledit contact interne (12),
D) la gravure à sec de ladite puce de silicium (13), la formation d'au moins un trou de substrat (14), jusqu'à ce que ladite première couche dudit premier matériau diélectrique dans ledit contact interne soit atteinte,
E) la gravure à sec de ladite première couche dudit premier matériau diélectrique au niveau de la partie inférieure dudit trou de substrat (14),

F) le dépôt d'une deuxième couche (16) d'un deuxième matériau diélectrique, ledit trou de substrat (14) étant ainsi rempli,

G) le dépôt et le modelage d'une couche de masque dur métallique mince (17), et la gravure à sec dans ladite deuxième couche dudit deuxième matériau diélectrique à l'intérieur dudit trou de substrat dans ladite puce de silicium, la formation d'un trou diélectrique (18) à l'intérieur dudit trou de substrat, moyennant quoi les parois latérales dudit trou de substrat restent couvertes par ladite deuxième couche dudit deuxième matériau diélectrique, jusqu'à ce que la partie inférieure dudit trou de substrat soit atteinte,

H) le dépôt d'une couche métallique épaisse (19), la création d'une interconnexion entre ledit contact ouvert (11) et ledit contact interne (12), transformant ainsi ledit trou diélectrique en un trou conducteur, et la gravure de ladite couche métallique épaisse (19),

I) le dépôt d'une troisième couche (20) d'un troisième matériau diélectrique, remplissant ainsi ledit trou conducteur.

2. Procédé selon la revendication 1, dans lequel ledit substrat (9) est une tranche de silicium.

3. Procédé selon la revendication 1 ou 2, dans lequel ledit trou de substrat (2) est de forme circulaire.

4. Procédé selon l'une quelconque des revendications 1 à 3, dans lequel ledit métal est de l'aluminium.

5. Procédé selon la revendication 1, dans lequel l'étape de gravure à sec de ladite puce de silicium (13) est réalisée par gravure à travers ladite puce de silicium jusqu'à ce que ladite couche d'oxyde soit atteinte.

6. Procédé selon la revendication 5, dans lequel l'étape de gravure à sec de ladite première couche du premier matériau diélectrique est réalisée par gravure de ladite couche d'oxyde.

7. Procédé selon l'une quelconque des revendications 1 à 6, dans lequel ledit deuxième matériau diélectrique et ledit troisième matériau diélectrique sont du benzocyclobutène (BCB) et ladite deuxième couche dudit deuxième matériau diélectrique et ladite troisième couche dudit troisième matériau diélectrique sont déposées par dépôt à la tournette de BCB.

8. Procédé selon l'une quelconque des revendications 1 à 7, comprenant en outre les étapes suivantes :

(J) la gravure à sec anisotrope dans ladite troisième couche de matériau électrique à l'intérieur dudit trou conducteur précédent, la formation d'au moins un trou diélectrique (4') à l'intérieur dudit trou conducteur précédent, moyennant quoi les parois latérales dudit trou conducteur précédent restent couvertes par ladite troisième couche de matériau diélectrique, jusqu'à ce que la partie inférieure dudit trou conducteur précédent soit atteinte,

(K) le dépôt d'une couche suivante de matériau conducteur (5') sur la partie inférieure et sur les parois latérales dudit trou diélectrique (4') dans ladite troisième couche de matériau diélectrique, transformant ainsi ledit trou diélectrique (4') en un trou conducteur,

(L) le dépôt d'une couche suivante d'un matériau diélectrique modelable supplémentaire (6') au-dessus de ladite couche suivante de matériau conducteur (5'), ledit trou conducteur étant ainsi rempli.

9. Procédé selon l'une quelconque des revendications 1 à 7, comprenant en outre les étapes suivantes :

(J) la gravure à sec anisotrope dans ladite troisième couche de matériau diélectrique à l'intérieur dudit trou conducteur précédent, la formation d'au moins un trou diélectrique (4') à l'intérieur dudit trou conducteur précédent, moyennant quoi les parois latérales dudit trou conducteur précédent restent couvertes par ledit troisième matériau diélectrique, jusqu'à ce que la partie inférieure dudit trou conducteur précédent soit atteinte,

(K) l'élimination de ladite couche métallique épaisse de la partie inférieure dudit trou diélectrique,

(L) le dépôt d'une couche suivante d'un matériau diélectrique modelable supplémentaire, moyennant quoi ledit trou diélectrique est rempli,

(M) la gravure à sec anisotrope dans ladite couche suivante de matériau diélectrique modelable à l'intérieur dudit trou diélectrique, la formation d'un nouveau trou diélectrique (4'b) à l'intérieur dudit trou diélectrique (4'), moyennant quoi les restes dudit trou diélectrique (4') restent couverts par ladite couche suivante de matériau diélectrique modelable, jusqu'à ce que la partie inférieure dudit trou de substrat soit atteinte,

(N) le dépôt d'une couche suivante de matériau conducteur (5') sur la partie inférieure et sur les parois latérales dudit nouveau trou diélectrique (4'b) dans ladite couche suivante de matériau diélectrique modelable, transformant ainsi ledit nouveau trou diélectrique (4'b) en un trou conducteur,

(O) le dépôt d'une couche suivante d'un matériau diélectrique modelable supplémentaire (6') au-dessus de ladite couche suivante de matériau conducteur (5').

10. Procédé pour la fabrication de dispositifs comprenant des interconnections électriques à trous traversants multiniveau selon la revendication 8, **caractérisé en ce qu'**il applique à nouveau les étapes supplémentaires (J, K, L) un nombre fini de fois.

11. Procédé pour la fabrication de dispositifs comprenant des interconnections électriques à trous traversants multiniveau selon la revendication 9, **caractérisé en ce qu'**il applique à nouveau les étapes supplémentaires (J, K, L, M, N, O) un nombre entier fini de fois.

12. Dispositif comprenant les interconnexions électriques à trous traversants, le dispositif comprenant :

> un substrat (9), d'ordinaire couvert par une couche d'oxyde (10) et comprenant un contact ouvert (11), avec une puce de silicium (13) collée sur ledit substrat, et dans lequel l'assemblage du substrat et de la puce comprend un contact interne (12),
> dans lequel un trou conducteur est formé au-dessus dudit contact interne, ledit trou conducteur comprenant
> un trou de substrat s'étendant à travers ladite puce de silicium jusqu'audit contact interne (12),
> une première couche diélectrique (16) formée sur les parois latérales dudit trou de substrat et sur la puce de silicium,
> une couche métallique (19) comprenant une première partie sur la couche diélectrique sur les parois latérales du trou de substrat, et
> une deuxième couche diélectrique (20) sur ladite couche métallique, la deuxième couche diélectrique remplissant le volume à l'intérieur du trou conducteur,
> et dans lequel la couche métallique (19) comprend en outre une deuxième partie au niveau de la partie inférieure du trou conducteur qui est en contact avec le contact interne, et une troisième partie s'étendant du trou conducteur jusqu'au contact ouvert (11), reliant ainsi le contact ouvert (11) et le contact interne (12).

**Fig. 1**

A — 1

B — 2  2

C — 3

D — 4

E — 5

F — 6

G1

G2 — 7

H — 8

EP 2 704 187 B1

**Fig. 2**

F

G1

G2f

H

EP 2 704 187 B1

Fig. 3

14

**Fig.4**

**Fig. 5**

F

D'    4'

Da

Db

Dc    4'b

E''    5'

F''    6'

LB

EP 2 704 187 B1

**Fig. 6**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6184060 B
- US 2002048916 A
- US 2002017710 A